# FASCICULE DE BREVET EUROPEEN

(11) **EP 0 546 921 B1**
(45) Date de publication et mention de la délivrance du brevet: **15.11.1995**
(21) Numéro de dépôt: 92403316.0
(22) Date de dépôt: 08.12.1992
(51) Int. Cl.: C23C 16/04, C23C 16/52

(54) **Photonanographe à gaz pour la fabrication et l'analyse optique de motifs à l'échelle nanométrique**
Gas-Photonanograph zur Herstellung und zur optischen Analyse von Mustern im Nanometerbereich
Gas photonanograph for fabrication and optical analysis of nanometer scale patterns

(30) Priorité: 13.12.1991 FR 9115496
(43) Date de publication de la demande: 16.06.1993
(73) Titulaire: FRANCE TELECOM, 75015 Paris (FR)
(72) Inventeur: Licoppe, Christian, F-75017 Paris (FR); Bensoussan, Marcel, F-92100 Boulogne (FR)
(74) Mandataire: Signore, Robert

(56) Documents cités:
- EP-A- 0 196 346
- FR-A- 2 623 820
- FR-A- 2 651 332
- US-A- 4 930 439

## Description

L'invention se rapporte à un dispositif de fabrication par voie gazeuse et d'analyse optique de motifs nanométriques. Ce dispositif sera appelé ci-après photonanographe à gaz. L'invention s'applique notamment dans le domaine de la fabrication des circuits intégrés utilisés en microélectronique, en microoptoélectronique et des systèmes optiques intégrés.

Le développement des circuits intégrés s'achemine de plus en plus vers la réduction des tailles et l'accroîssement de la densité d'intégration. De plus, l'accès aux dimensions submicroniques ouvre la perspective d'exploiter des effets nouveaux d'origine quantique dans des dispositifs originaux.

Les facteurs d'encombrement, de coût et de complexité des techniques de nanofabrication (fabrication à l'échelle nanométrique) semblant croître en raison inverse de la taille des dispositifs, il devient important pour les applications industrielles de concevoir des techniques de nanolithographie, de nanogravure et de nanofabrication qui limitent ces facteurs.

De plus, à ces échelles de dimension, la visualisation et l'évaluation in situ des propriétés des structures fabriquées deviennent des problèmes délicats ; il est donc du plus grand intérêt de construire des outils expérimentaux assez versatiles pour assurer simultanément les fonctions de fabrication, de visualisation et d'analyse, et tout particulièrement d'analyse des propriétés optiques des structures dont les dimensions sont de l'ordre du nanomètre (appelées nanostructures).

Les techniques connues de fabrication de dispositifs submicroniques peuvent être réparties en deux classes : une première classe utilisant des faisceaux de particules, focalisés et une seconde classe utilisant des pointes submicroniques approchées de l'échantillon à des distances également submicroniques.
1°) - A l'intérieur de la première classe, on peut distinguer différentes techniques en fonction du type de particules utilisées.
   Dans cette première classe, les techniques les plus couramment utilisées emploient des faisceaux optiques de courte longueur d'onde, UV et X, des faisceaux d'électrons ou des faisceaux d'ions, voir à cet effet le document de T.H.P. Chang et al., "Nanostructure Technology", IBM Journal of Research and Development 32(4), p. 462-493, 1988.
   La lithographie UV par projection ou holographie est relativement simple et fiable jusqu'à des tailles d'objet de l'ordre de 0,2µm. Malheureusement, pour des tailles d'objet inférieures, il faut recourir al des techniques utilisant des faisceaux X, ioniques ou électroniques, ces derniers étant les plus couramment employés, voir à cet effet le document de S. Mackie et al., "Materials and processes for nanometer lithography", Solid State Technology, p. 117-122, 1985.
   A l'intérieur de ces techniques, il faut encore distinguer, d'une part les nanolithographies opérant par des réactions localisées sur des résines photosensibles intermédiaires, soit par projection au travers de masques, soit par écriture directe, et d'autre part, les dépôts et attaques en milieu réactif; pour les dépôts et attaques, le faisceau de particules focalisé sur l'échantillon stimule directement une réaction localisée dans le milieu réactif et le motif est écrit par déplacement séquentiel du faisceau sur l'échantillon.
   Dans ces dernières configurations en milieu réactif, à l'exception du cas très particulier où les éléments réactifs sont ceux qui composent le faisceau de particules, une des difficultés consiste à avoir une buse d'introduction des réactifs suffisamment convergente pour minimiser la taille de la zone irradiée par les gaz.
   D'une manière générale, les techniques de nanofabrication par faisceaux X, ioniques et électroniques sont des techniques lourdes et coûteuses, nécessitant en particulier des sources de particules d'une extrême sophistication. D'autre part, lorsqu'elles permettent d'effectuer des analyses in situ des nanomotifs qu'elles ont permis de fabriquer, c'est uniquement sous les angles structuraux accessibles aux outils comme la microscopie X ou la microscopie électronique, c'est-à-dire une description spatiale des motifs avec une résolution nanométrique et éventuellement une analyse de la qualité cristalline par diffraction. Ceci constitue une sévère limitation des techniques d'analyse lorsque les propriétés les plus intéressantes des nanostructures sont d'ordre électronique ou optique.
2°) - Le développement de la microscopie à effet tunnel utilisant une pointe submicronique a ouvert la voie de la seconde classe de nanofabrication.

En contrôlant la tension de la pointe à effet tunnel, il est possible d'agir localement sur des résines hotosensibles (voir le document de M.A. McCord et al., "Lift-off metallization using PMMA exposed with a scanning tunneling microscope", Journal of Vacuum Science and Technology, B4, p. 86, 1986), de déposer des métaux dans un environnement organométallique réactif aux électrons émis par effet tunnel (voir à cet effet le document de E.E. Ehrichs et al., "Direct writing with the STM", Journal of Vacuum Science and Technology, A6, p. 540-543, 1988), de déplacer des atomes et d'induire des modifications variées des surfaces à une échelle aussi petite que l'atome isolé (voir à cet effet le document de E.J.Van Loenen et al., "Direct writing in Si with a scanning tunneling microscope", Applied Physics Letters 55(13), p. 1312-1314, de septembre 1989).

De plus, le microscope à effet tunnel permet, en modulant le courant produit par effet tunnel, des analyses in situ d'ordre électronique.

L'intensité du courant électrique émis par effet tunnel est limitée par la résistance électrique de l'échantillon à analyser. La principale limitation de cette technique est donc de ne pouvoir être mise en oeuvre que sur des substrats conducteurs, métalliques ou semi-conducteurs très dopés. Dans ce dernier cas, une analyse spectroscopique de la distribution spatiale des états d'énergie vides et pleins est possible in situ par la modulation du courant de l'effet tunnel.

Il existe à côté de la microscopie par effet tunnel d'autres microscopies dites "en champ proche" comme en particulier la microscopie optique en champ proche décrite dans le document de D. Pohl, "Scanning near-field optical microscopy", Advances in Optical and Electron Microscopy, édité par C.R.J, Sheppard et T. Mulvey Academic Press, Londre 1991, p. 1 à 29.

Dans cette technique, une fibre en silice épointée par traitement mécano-chimique (voir à ce sujet le document de D. Courjon et al., "Scanning tunneling optical microscopy", Optical Communications, vol. 12, p. 23-28, 1989) ou une micropipette creuse (se référer au document de A. Harootunian et al., "Super resolution fluorescence near-field scanning optical microscopy", Applied Physics Letters, 49(11), p. 674,676, 1986), est amenée par des déplacements piézoélectriques au voisinage de l'échantillon de analyser dans une proximité contrôlée à une fraction de nanomètre près ; le rayon de courbure de la pointe de la fibre ou de la micropipette est à l'échelle de la dizaine de nanomètres.

Ce dispositif peut fonctionner en mode illumination-réflexion dans lequel la lumière incidente et la lumière réfléchie passent toutes deux par la pointe, comme décrit dans le document de A. Harootunian et al. cité précédemment, et en mode collection de lumière dans lequel l'illumination se fait de côté ou par l'arrière de l'échantillon lorsque celui-ci est transparent et lorsque la pointe n'est utilisée que pour collecter en régime de champ proche une partie de la lumière réfléchie ou transmise (comme décrit dans le document de U.C. Fisher et D.W. Pohl, "Observation of single particles plasmons by near-field optical microscopy", Physical Review Letters, vol. 62(4), p. 458-461, 1989).

Il peut aussi fonctionner en mode tunnel optique dans lequel la pointe se couple à l'onde évanescente qui subit de multiples réflexions totales à l'intérieur du substrat transparent à analyser, comme décrit dans le document de E. Betzig et al., "Collection mode near-field scanning optical microscopy", Applied Physics Letters, 51(25), p. 2088-2090, décembre 1987.

Comme autres documents relatifs à un microscope "en champ proche", on peut citer les demandes de brevet FR-A-2 651 332, FR-A-2 653 906 et FR-A-2 654 212.

Quel que soit le mode de fonctionnement utilise en microscopie en champ proche, la pointe permet actuellement d'effectuer une analyse microscopique résolue à 10nm près et des mesures spectroscopiques dans le domaine optique visible et proche infrarouge avec cette même résolution spatiale.

Parallèlement, les techniques connues de dépôts en phase gazeuse assistes par rayonnement électromagnétique, pyrolytique ou photolytique, présentent actuellement une résolution spatiale limitée par la longueur d'onde du faisceau utilise, du fait de la limite de diffraction, ce qui impose de travailler dans l'ultraviolet lointain pour obtenir une résolution des motifs à l'échelle nanométrique.

L'invention a justement pour objet un dispositif de fabrication par voie gazeuse et d'analyse optique de motifs à échelle nanométrique permettant notamment de remédier aux inconvénients ci-dessus.

Ce dispositif est destine aux dépôts et aux gravures de motifs nanométriques et à leur contrôle in situ. Il permet en particulier de s'affranchir de la limitation en longueur d'onde pour les dépôts et gravures assistes par rayonnement et de décorréler résolution et longueur d'onde du faisceau excitateur. Il permet donc d'exploiter toutes les résonances spectroscopiques (ultraviolet, visible, infrarouge) associées aux réactions chimiques de dépôt et de gravure indépendamment des contraintes liées à la taille des motifs, contrôlée par d'autres aspects du dispositif. En libérant le choix du rayonnement utilise des contraintes associées aux limites de diffraction d'Abbe, le dispositif offre donc la possibilité de mieux optimiser les rendements photochimiques des réactions nécessaires aux dépôts ou à la gravure.

De façon plus précise, l'invention a pour objet un dispositif de fabrication par voie gazeuse et d'analyse optique de motifs nanométriques sur un échantillon, comportant une chambre de détente à gaz, fermée, étanche, équipée de premiers moyens d'alimentation en gaz destiné à la fabrication des motifs et pourvue à une première extrémité de microcapillaires destinés à la sortie du gaz, une fibre optique épointée à une première extrémité, destinée à être placée en regard de l'échantillon à traiter, une source de lumière couplée à une seconde extrémité de la fibre optique, cette dernière étant apte à véhiculer la lumière émise par la source, des moyens pour détecter et des moyens pour traiter le signal lumineux réfléchi par l'échantillon.

De préférence, le dispositif comporte, en outre, une chambre de réserve de gaz, équipée de moyens d'alimentation en gaz et notamment rendue solidaire de la chambre de détente pour former un ensemble unitaire. En particulier, les chambres de détente et de réserve sont disposées bout à bout et coaxialement. Toutefois, elles pourraient être disposées côte à côte ou simplement être séparées et reliées entre elles par une conduite d'alimentation en gaz.

Le dispositif de l'invention, grâce à une double intégration, permet le dépôt ou la gravure de motifs de dimensions nanométriques par voie gazeuse tout en assurant in situ leur contrôle par voie optique.

En intégrant tout d'abord une fibre optique épointée à une enceinte étanche remplie de gaz et munie de microcapillaires de sortie de gaz d'un robinet d'arrêt et d'une prise de raccordement pour une seconde fibre optique, externe au dispositif, on obtient un photonanographe pour le nanodépôt et/ou la nanogravure de motifs par les procédés photothermiques et/ou photolytiques bien connus de l'homme de l'art dont la fonction est ainsi double.

En réalisant la fibre optique solidaire de l'enceinte dans un matériau à profil d'indice tel que la lumière émise par les sources utilisées (ultraviolettes, visibles ou infrarouges) soit guidée et ne soit pas atténuée, il est possible de faire arriver un faisceau lumineux excitateur sur l'échantillon en même temps que le gaz réactif, de sorte qu'à la surface de l'échantillon, une réaction photochimique ne soit possible qu'en régime de champ proche, dans lequel le faisceau lumineux excitateur reste focalisé tout en s'affranchissant des limites de diffraction, qui interviennent à l'échelle de la longueur d'onde utilisée.

De façon avantageuse, la partie épointée de la fibre peut être recouverte d'une couche externe de forte réflexibilité à la longueur d'onde du faisceau incident émis par la source, à l'exception de l'extrémité la plus pointue de la fibre qui guide la lumière et qui se trouve directement en regard de la surface à traiter. De cette manière, on assure une meilleure localisation du faisceau d'irradiation.

De façon avantageuse, la fibre optique solidaire de l'enceinte est équipée à sa seconde extrémité d'une prise de raccordement standard, de sorte que n'importe quel système, source lumineuse plus fibre de sortie, peut venir s'y raccorder. On peut alors avantageusement, au cours de l'utilisation du dispositif, changer la nature de la lumière qui irradie l'échantillon en fonction des besoins. (Ainsi, une fibre optique de couplage peut être montée sur la prise de raccordement pour coupler la fibre optique épointée à une source quelconque de lumière).

Il est toutefois possible de n'utiliser qu'une seule fibre optique entre l'échantillon et la source de lumière.

De façon avantageuse, les microcapillaires sont disposes en couronne autour de la fibre optique et sont notamment orientés obliquement par rapport à la fibre optique de façon à obtenir une distribution homogène de gaz réactifs au voisinage de la pointe de la fibre et juste au-dessus de l'échantillon.

Le diamètre de passage des gaz, assure par les microcapillaires au voisinage de la pointe de la fibre optique peut être rendu typiquement quatre ordres de grandeur plus petit que la tuyauterie conventionnelle et le volume des chambres de détente et de réserve à remplir de gaz peut être rendu cinq ordres de grandeur plus faibles que celui d'un réacteur connu de dépôt ou de gravure chimique en phase vapeur (CVD).

Ainsi, avec le dispositif de l'invention, une charge de gaz actif de quelques dizaines de cm³ (10 à 100cm³ par exemple) à une pression de quelques centaines de kilopascals (2 à 10x10³ kPa par exemple) suffit à assurer les mêmes conditions de débit et de pression totale de gaz que dans le depôt ou la gravure CVD basse pression classique utilisant une bouteille de gaz de 10 litres chargée à 2x10⁴ kPa alimentant en gaz un réacteur de 1dm³ avec un débit de 100cm³/s et une pression de l'ordre de 1kPa.

L'ensemble fibre optique-alimentation de gaz peut donc être intégré dans un dispositif autonome dont les dimensions sont de l'ordre de quelques centimètres, faisant ainsi l'économie de tous les systèmes d'injection des gaz propres au dépôt ou gravure CVD et par conséquent, réalisant des gains de place, de sécurité, et de coût importants par rapport à un dispositif de dépôt ou de gravure à gaz réactif, classique.

La charge gazeuse peut être conçue soit comme un système dont le contenu peut être renouvelable autant que de besoin, soit au contraire comme un système scellé avec la possibilité de changer à volonté et séparément l'ensemble pointe et charge gazeuse.

Le dispositif de l'invention présente l'avantage, par rapport aux dispositifs de gravure ou de dépôt CVD de l'art antérieur, de pouvoir travailler avec des sources lumineuses, laser ou même de simples lampes émettant dans toute la gamme de longueur d'onde allant de l'infrarouge à l'ultraviolet et de pouvoir accéder à tout les types de traitement de signaux lumineux possibles. Ainsi, il permet de s'affranchir des nombreuses difficultés techniques liées au développement de sources X, électroniques ou ioniques possédant le grand degré de stabilité et de brillance nécessaire pour ce type d'application.

Le deuxième niveau d'intégration du dispositif de l'invention est d'utiliser le photonanographe comme un microscope optique en champ proche dont la pointe, destinée à l'imagerie, est justement contituée par la pointe de la fibre optique du photonanographe. Ce microscope optique peut fonctionner en mode de réflexion-absorption, en mode de collection ou en mode tunnel optique.

Tout intégré avec son système de déplacement pour la mise au point sur l'échantillon et de contrôle de la source, dans l'état actuel de la technique, l'ensemble du dispositif peut être réduit à un espace inférieur au dm³ et s'insère donc aisément dans de nombreuses configurations expérimentales, et ce, d'autant plus qu'avec sa charge gazeuse intégrée, il s'avère parfaitement autonome.

Les domaines privilégiés d'utilisation du dispositif de l'invention sont l'écriture par dépôts pyrolytique et photolytique de matériau, localisés, en phase vapeur, et la photoablation réactive, le dépôt photolytique et la photoablation pouvant éventuellement être combinés.

Aussi, l'invention a encore pour objet un procédé de dépôt direct pyrolytique, localisé, d'un matériau sur un échantillon utilisant le dispositif ci-dessus, consistant à irradier l'échantillon par un faisceau lumineux émis par la source de lumière et transmis par la fibre optique pour chauffer l'échantillon et simultanément à soumettre l'échantillon à des précurseurs gazeux dudit matériau, via les microcapillaires.

En particulier, ce procédé de dépôt pyrolytique peut s'appliquer au dépôt de silicium, de germanium, de diélectrique de composé III-V ou II-VI, les précurseurs gazeux étant des hydrures et/ou des organométalliques. Pour le dépôt de silicium, on utilise par exemple du silane (SiH₄) ; pour le dépôt de germanium, on utilise du germane ou du triméthyl germanium (TMGa) ; pour le dépôt de GaAs, on peut utiliser un mélange de TMGa et de AsH₃ ; pour le dépôt de ZnSe, on peut utiliser un mélange de triméthyl zinc et de SeH₃, etc...

L'invention a encore pour objet un procédé de dépôt localisé d'un matériau, assisté photochimiquement utilisant le dispositif décrit ci-dessus. En particulier, ce procédé peut être appliqué au dépôt local de silice en utilisant comme précurseurs gazeux du silane et de l'oxygène ou au dépôt local de nitrure de silicium en utilisant comme précurseur gazeux du silane et de l'ammoniac.

L'invention a encore pour objet un procédé de gravure localisée d'un matériau, assistée photochimiquement, utilisant le dispositif ci-dessus. En particulier, les gaz réactifs utilisés pour la gravure sont à base d'halogènes.

Il est également possible d'envisager des applications de type nanolithographique dans des couches de résine photosensibles suffisamment minces, avec la possibilité de réaliser l'étape d'irradiation et de révélation des résines en une seule étape selon un procédé de "lift-off" par exemple.

Aussi, l'invention a encore pour objet un procédé de fabrication direct de motifs de résine photosensible utilisant le dispositif ci-dessus.

De plus, l'ensemble du dispositif possède la capacité, unique à l'heure actuelle, d'assurer simultanément la fabrication de nanomotifs et leur observation par des techniques optiques, en particulier spectroscopiques (UV, visible ou IR).

Par ailleurs, le dispositif de l'invention s'applique à tout type de surface (isolante, semi-conductrice par exemple) et pas seulement aux surfaces conductrices que nécessitait jusqu'alors l'usage du microscope électronique à effet tunnel.

le dispositif de l'invention est utilisable avec une large gamme de gaz ou mélanges de gaz et avec une très large gamme de sources optiques (lampe ou laser émettant dans l'UV, visible ou infrarouge) ; il peut s'appliquer à toutes sortes de gravures et de dépôts (métaux, semi-conducteurs ou isolants) et à toutes sortes de substrats (verres, métaux, semi-conducteurs) recouverts ou non d'une résine photosensible.

D'autres caractéristiques et avantages de l'invention ressortiront mieux de la description qui va suivre, donnée à titre illustratif et non limitatif, en référence aux figures annexées, sur lesquelles :
- la figure 1 représente schématiquement un photonanographe à gaz conforme à l'invention,
- la figure 2 représente schématiquement, en coupe et de façon plus détaillée, la pointe métallisée de la fibre optique du dispositif de la figure 1, et
- la figure 3 représente en perspective et de façon détaillée, l'agencement des microcapillaires du dispositif de la figure 1.

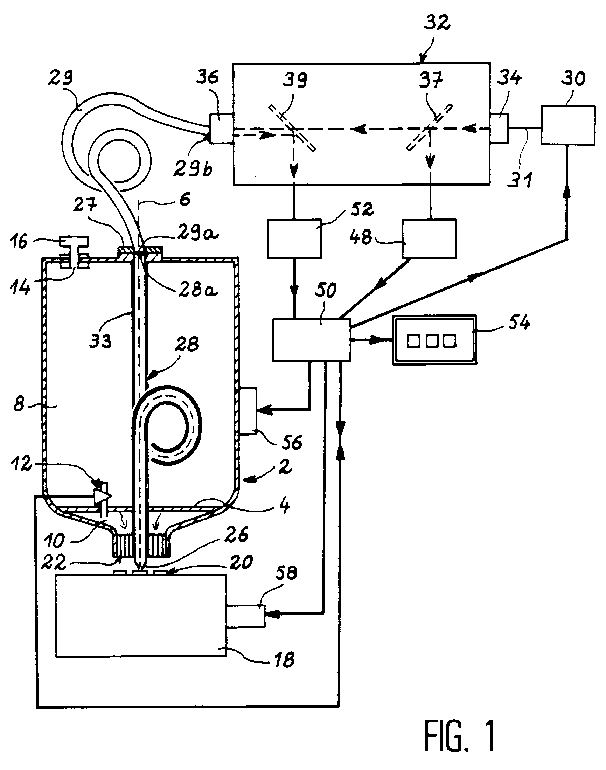

En référence aux figures 1 à 3, le dispositif de fabrication et d'analyse de motifs nanométriques conformément à l'invention comporte un réservoir 2 fermé étanche, en forme de bouteille, équipé dans sa partie inférieure d'une paroi 4 disposée perpendiculairement à l'axe 6 de symétrie du réservoir et définissant deux chambres de gaz solidaires, coaxiales et aboutées, une chambre supérieure de réserve 8 et une chambre de détente 10. Une vanne à fuite 12 montée sur la paroi 4 permet de mettre en communication les chambres 8 et 10 et de régler le débit de gaz sortant du dispositif.

La chambre 8 de réserve de gaz définit un volume de gaz supérieur à celui de la chambre de détente 10.

Le réservoir 2 est équipé à sa partie supérieure d'un orifice 14 destiné au remplissage de la chambre 8, que l'on obture avec un bouchon 16.

Ces deux chambres 8 et 10 assurent l'autonomie fonctionnelle du dispositif de l'invention et permettent de le réapprovisionner régulièrement en gaz réactif.

Par exemple, le réservoir 2 peut renfermer de 20 à 50 cm³ de gaz réactif sous une pression de 10³Pa.

L'extrémité ou goulot du réservoir 2, destiné à être placé en regard de l'échantillon 18 devant être gravé ou recouvert localement d'un matériau 20, est équipé d'un bouchon 22 muni de microcapillaires 24 destinés à la sortie du gaz réactif contenu dans la chambre de détente 10. Ces microcapillaires 24 sont disposés en couronne pour assurer une distribution homogène de gaz, en surpression, au voisinage de l'échantillon 18.

En particulier, les axes longitudinaux de ces microcapillaires 24 (figure 3) sont inclinés par rapport à l'axe 6 du réservoir afin de diriger les pinceaux gazeux 25 vers la pointe 26 d'une fibre optique 28, traversant de part en part le réservoir 2 ainsi que le bouchon 22. Cette fibre peut être disposée avantageusement dans le réservoir pourvu que sa pointe 26 fasse saillie hors du bouchon 22.

La fibre optique est solidaire du réservoir 2 par ses extrémités seulement. L'extrémité 28a de la fibre 28, opposée à la pointe 26 est raccordée à l'entrée du réservoir 2 à une prise de raccordement 27 pour fibre optique. Cette prise de raccordement est montée à l'extérieur du réservoir 2.

La fibre 28 peut avantageusement être recouverte d'une gaine souple opaque 33 qui la protège des gaz réactifs qui se trouvent dans les chambres 8 et 10.

La pointe 26 de la fibre optique est obtenue par un traitement mécanochimique. Elle présente une extrémité arrondie 26a ayant un rayon de courbure a de 30 à 100nm.

La disposition en couronne des microcapillaires autour de la pointe 26 assure un flux homogène et symétrique de gaz.

Avec 25 microcapillaires de 200µm² de section chacun dont les extrémités 24a en regard de l'échantillon sont placées à une distance d de 1cm de la fibre optique 28, une pression gazeuse 10³Pa et un coefficient de collage de 0,01 des atomes gazeux sur l'échantillon 18, on réalise un régime de dépôt tel que l'on dépose une monocouche de matériau 20 par seconde.

La vanne à fuite 12 et la chambre de détente 10, placée entre la chambre 8 de réserve de gaz et les microcapillaires 24, permettent de contrôler la pression de gaz dans les capillaires et de moduler le flux gazeux arrivant sur l'échantillon 18.

L'extrémité 28a de la fibre optique 28 est connectée, via la prise de raccordement 27 pour fibre optique, à une première extrémité 29a d'une seconde fibre. L'autre extrémité 29b de cette seconde fibre est couplée à une source de lumière 30, du type lampe ou diode laser. Le couplage est assuré par un ensemble optique 32 comportant une lentille de collimation d'entrée 34 pour collimater le faisceau incident 31, deux cubes séparateurs 37 et 39 inclinés à 45° environ par rapport au faisceau incident 31 et une lentille de focalisation de sortie 36 pour focaliser le faisceau incident à l'extrémité 29b de la fibre optique 29.

L'emploi d'une fibre optique de couplage 29 assure la possibilité de changer rapidement cette fibre et donc la source de lumière.

Les fibres optiques 28 et 29 doivent être transparentes à la longueur d'onde d'émission de la source 30, cette longueur d'onde étant appropriée à l'application particulière envisagée. En particulier, les fibres optiques sont réalisées en silice. Elles sont constituées, par exemple, d'un coeur entouré d'une couche à profil d'indice assurant un guidage efficace, et éventuellement d'une gaine protectrice.

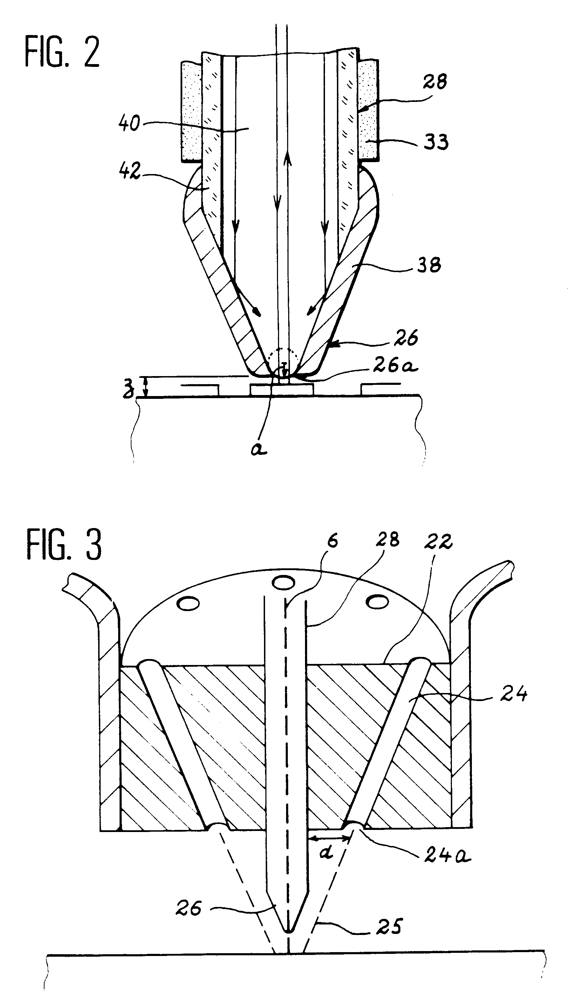

Sur la figure 2, les références 40 et 42 indiquent respectivement le coeur et la couche à profil d'indice de la fibre 28.

Cependant, la fibre optique 28 est recouverte (figure 2) sur sa partie amincie 26, à l'exception de son extrémité la plus étroite 26a, sur une région de la taille du rayon de courbure a, d'un revêtement métallique 38, de façon à ne laisser sortir la lumière de la fibre que par son extrémité 26a. Ce revêtement 38 est par exemple constitué d'une couche de chrome assurant l'adhésion, recouverte d'une couche d'argent, déposées par évaporation. La métallisation 38 assure le confinement de la lumière dans la partie 26 amincie, là où la fibre ne guide plus la lumière.

Le cube séparateur 37 permet de prélever une partie de la lumière incidente 31 en vue de la contrôler. La partie prélevée est donc envoyée sur un détecteur 48 du type photodiode transformant le signal lumineux en un signal électrique. Ce détecteur est connecté à un circuit de traitement 50 du type microprocesseur qui, en fonction du signal émis par le détecteur 48 modifie les caractéristiques d'émission de la source 30. Ce système, non essentiel, sert à réguler l'intensité de la lumière traversant la fibre optique 28.

L'autre partie du faisceau incident est acheminée sur l'échantillon à traiter via la fibre optique 29, en vue du traitement (dépôt ou gravure) du matériau 20 et/ou du contrôle dudit matériau.

La fibre optique 29 est destinée non seulement à transmettre les informations lumineuses issues de la source 30 vers l'échantillon 18 mais aussi à transmettre la lumière réfléchie par l'échantillon 18. La lumière issue de l'échantillon est reçue, via la lentille 36, par le second cube séparateur 39. La lumière réfléchie par ce cube séparateur 39 est alors détectée par un détecteur 52 du type photodiode qui transforme le signal lumineux réfléchi en un signal électrique.

Ce détecteur 52 est connecté au circuit de traitement 50 en vue d'un contrôle du dépôt ou gravure local 20 effectué sur l'échantillon 18. De plus, le circuit 50 pilote un écran de visualisation 54 en vue d'une visualisation éventuelle du matériau 20 déposé ou gravé.

En outre, le circuit de traitement 50 pilote l'ouverture et la fermeture de la vanne 12, afin de réguler le débit et la pression du gaz réactif dans la chambre de détente 10 et dans les microcapillaires.

Aux fins de visualisation, un système de mise au point sur l'échantillon doit être prévu. Ce système peut consister en une ou plusieurs céramiques piézoélectriques 56 solidaires du réservoir 2 et commandées par le circuit de traitement 50 et éventuellement en une ou plusieurs céramiques piézoélectriques 58 solidaires de l'échantillon, pilotées aussi par le circuit de traitement 50.

Le cube séparateur 39 à l'entrée de la fibre optique 29 distingue, grâce à la polarisation, la lumière réfléchie par l'échantillon 18 de la lumière incidente. La photodiode 52 qui reçoit cette lumière réfléchie en mesure l'intensité lumineuse et le circuit de traitement 50 en déduit la distance z séparant l'extrémité 26a de la pointe 26 et l'échantillon 18.

En jouant sur les tensions appliquées aux céramiques piézoélectriques 56 ou 58, on fait varier la distance z. A 10 nanomètres de l'échantillon environ, l'intensité lumineuse de la lumière réfléchie croît exponentiellement.

Le dispositif de l'invention peut être utilisé pour un dépôt pyrolytique local de matériau. Il permet de contrôler l'élévation de température induite sur l'échantillon 18 par un faisceau laser 31 intense (par exemple laser de puissance argon visible ou CO₂ infrarouge) traversant la fibre 28, combiné à une température de chauffage de l'échantillon 18 appropriée en vue de stimuler une réaction localisée à la surface de l'échantillon 18. L'élévation de température localement sur l'échantillon s'applique très bien au dépôt localisé de silicium, de diélectriques ou de composés III-V à partir d'hydrures et d'organométalliques.

L'ensemble du photonanographe à gaz de l'invention est susceptible d'être inséré dans une chambre de réaction sous vide en vue de réaliser des gravures ou des dépôts de matériau sous vide.

De façon avantageuse, la pression régnant dans la chambre de réaction est choisie telle que le libre parcours moyen des molécules dans la chambre soit plus petit que la distance z séparant l'extrémité 26a de la pointe de l'échantillon (typiquement de l'ordre de 10⁴Pa).

Ainsi, le dispositif de l'invention peut être utilisé pour un dépôt ou une gravure locale d'un matériau, assisté photochimiquement. Dans ce cas, on utilise comme faisceau incident 31 un faisceau excitateur, par exemple ultraviolet. La réaction photo-assistée ne peut alors se produire qu'à la surface de l'échantillon éclairé. En particulier, un photodépôt localisé de silice peut être obtenu à partir d'un mélange de silane et d'oxygène.

Dans ce cas particulier, on insère le photonanographe à gaz de l'invention dans une enceinte contenant une atmosphère d'oxygène et on remplit le réservoir 2 de silane afin de l'envoyer sur l'échantillon. Le rayonnement UV émis par la source est avantageusement choisi entre 160 et 200nm. Typiquement, on utilise comme source de lumière un laser à excimère émettant à 193nm.

Cette longueur d'onde est absorbée par l'oxygène contrairement au silane ; le silane réagit sur les espèces photoexcitées de l'oxygéne, uniquement en surface de l'échantillon. Dans ces conditions, on obtient le photodépôt localisé de nanomotifs de silice. La taille caractéristique des motifs est du même ordre de grandeur que le rayon de courbure a de l'extrémité 26a de la pointe additionnée de deux fois la longueur de diffusion des molécules de gaz.

Avec le dispositif de l'invention, il est aussi possible d'effectuer des dépôts localisés, assistés photochimiquement, de métaux. Dans ce cas, on utilise le déplacement des raies de résonance d'une molécule du gaz réactif capable d'être adsorbée sur l'échantillon. En excitant spécifiquement les raies de résonance de la phase adsorbée, on n'engendre une réaction de dépôt que sur la surface de l'échantillon illuminée.

Ce procédé de depôt localise peut être utilise en particulier pour réparer des circuits intégrés ou pour réaliser des masques de résine pour gravure ou pour implantation ionique.

Le dispositif de l'invention est aussi adapté à la nanogravure. Il permet ainsi d'éviter l'étape de transfert de masque de résine photosensible qui reste en nanolithographie l'un des facteurs limitatifs de réussite. Dans ce cas, on effectue une attaque chimique localisée du matériau 20 en le soumettant à des gaz réactifs notamment à base d'iode, de brome, de fluor ou de chlore suivant la nature du matériau à graver pendant qu'on le soumet localement, via la fibre optique épointée, à un faisceau ultraviolet 31.

Le dispositif de l'invention peut encore être utilise pour la nanolithographie par écriture directe de motifs sur une résine photosensible. Il offre la possibilité de réaliser en même temps les étapes d'irradiation et de révélation de la résine par voie réactive.

En effet, l'irradiation de la résine est assurée par le faisceau lumineux 31 sortant de la pointe 26 de la fibre optique et la révélation des motifs est assurée par le gaz sortant par les microcapillaires. En particulier, on peut utiliser une source de lumière ultraviolette émettant autour de 200nm pour l'irradiation et de l'oxygène comme gaz d'attaque des résines photosensibles.

Avec la même pointe 26, on illumine l'échantillon 18 avec de la lumière visible ou infrarouge émise par la source 30 suivant le type de contrôle recherché pour le dépôt. Ainsi, en promenant la pointe 26 au-dessus des motifs nanométriques déposés ou gravés, on peut analyser, morphologiquement (en lumière visible) ou spectroscopiquement (en lumière infrarouge) les motifs, immédiatement après leur dépôt ou gravure. Les résultats de cette analyse peuvent être affichés sur l'écran de visualisation 54.

## Revendications

1. Dispositif de fabrication par voie gazeuse et d'analyse optique de motifs nanométriques sur un échantillon, comportant une chambre de détente à gaz (10), fermée, étanche, équipée de premiers moyens (12) d'alimentation en gaz destiné à la fabrication des motifs et pourvue à une première extrémité de microcapillaires (24) destinés à la sortie du gaz, une fibre optique (28) épointée (26) à une première extrémité, destinée à être placée en regard de l'échantillon (18) à traiter, une source de lumière couplée à une seconde extrémité (28a) de la fibre optique émettant un faisceau incident (31), cette dernière étant apte à véhiculer le faisceau émis par la source, des moyens (48, 52) pour détecter et des moyens pour traiter (50) le signal lumineux réfléchi par l'échantillon.

2. Dispositif selon la revendication 1, caractérisé en ce que les microcapillaires (24) sont disposés en couronne autour de la pointe (26) de la fibre optique.

3. Dispositif selon la revendication 1 ou 2, caractérisé en ce que les microcapillaires sont inclinés par rapport à la pointe de la fibre optique.

4. Dispositif selon l'une quelconque des revendications 1 à 3, caractérisé en ce que la chambre de détente est fermée à sa première extrémité par un bouchon (22) équipé desdits microcapillaires et en ce que la première extrémité de la fibre optique traverse le bouchon de sorte que sa pointe fasse saillie hors du bouchon.

5. Dispositif selon l'une quelconque des revendications 1 à 4, caractérisé en ce qu'une chambre (8) de réserve en gaz, équipée de seconds moyens (14) d'alimentation en gaz, est prévue.

6. Dispositif selon la revendication 5, caractérisé en ce que les deux chambres (8, 4) sont solidaires et destinées à être mises en communication via lesdits premiers moyens.

7. Dispositif selon la revendication 6, caractérisé en ce que les deux chambres (8, 4) sont disposées bout à bout et coaxialement et destinées à être mises en communication via lesdits premiers moyens.

8. Dispositif selon l'une quelconque des revendications 1 à 7, caractérisé en ce que des moyens (37, 39) pour séparer le faisceau incident issu de la source lumineuse sont prévus de façon à produire un premier faisceau lumineux destiné à l'analyse et/ou au traitement de l'échantillon et un second faisceau destiné à contrôler le faisceau émis par la source.

9. Dispositif selon l'une quelconque des revendications 1 à 8, caractérisé en ce que des moyens de visualisation (54), connectés aux moyens de traitement sont prévus.

10. Dispositif selon l'une quelconque des revendications 1 à 9, caractérisé en ce que la partie épointée de la fibre optique en regard de l'échantillon est recouverte, dans sa partie amincie à l'exception de son extrémité (26a) la plus pointue, d'une couche externe (38) de forte réflexibilité à la longueur d'onde du faisceau incident issu de la source.

11. Dispositif selon l'une quelconque des revendications 1 à 10, caractérisé en ce que la fibre optique est recouverte en partie d'une couche métallique.

12. Dispositif selon l'une quelconque des revendications 5 à 11, caractérisé en ce que la fibre optique est recouverte sur sa longueur, à l'intérieur des chambres de détente et de réserve (8, 10), d'une gaine (33) qui la protège des gaz réactifs qui s'y trouvent.

13. Dispositif selon l'une quelconque des revendications 1 à 12, caractérisé en ce que la seconde extrémité (28a) de la fibre (28) épointée est équipée d'une prise de raccordement standard (27) pour fibre optique et en ce qu'une fibre optique de couplage (29) assure le couplage de la fibre optique épointée (28) à la source de lumière.

14. Dispositif selon l'une quelconque des revendications 1 à 13, caractérisé en ce que des moyens (56, 58, 50) sont prévus pour effectuer un déplacement relatif entre la pointe (26) de la fibre optique et l'échantillon (18) en vue d'une mise au point.

15. Dispositif selon l'une quelconque des revendications 1 à 14, caractérisé en ce qu'il constitue un ensemble autonome.

16. Procédé de dépôt direct pyrolytique, localisé, d'un matériau sur un échantillon, caractérisé en ce qu'il consiste à utiliser le dispositif selon l'une quelconque des revendications 1 à 15, à irradier l'échantillon (20) par un faisceau lumineux (31) émis par la source de lumière et transmis par la fibre optique pour chauffer ledit échantillon et simultanément à soumettre l'échantillon à des précurseurs gazeux dudit matériau, via les microcapillaires.

17. Procédé selon la revendication 16, appliqué au dépôt local de silicium, de diélectrique ou d'un composé III-V, caractérisé en ce que les précurseurs gazeux sont des hydrures et/ou des organométalliques.

18. Procédé de dépôt localisé d'un matériau sur un échantillon, assisté photochimiquement, caractérisé en ce qu'il consiste à utiliser le dispositif selon l'une quelconque des revendications 1 à 14, à exposer l'échantillon à un faisceau lumineux émis par la source de lumière et transmis par la fibre optique, et simultanément à soumettre l'échantillon à des précurseurs gazeux dudit matériau, via les microcapillaires.

19. Procédé selon la revendication 18, appliqué au dépôt local de silice, caractérisé en ce que les précurseurs gazeux sont le silane et l'oxygène, en ce que l'on place le dispositif et l'échantillon dans une atmosphère d'oxygène et en ce que l'on soumet le substrat au silane via les microcapillaires.

20. Procédé de gravure localisée d'un matériau, assistée photochimiquement, caractérisé en ce qu'il consiste à utiliser le dispositif selon l'une quelconque des revendications 1 à 14, à soumettre l'échantillon à un faisceau lumineux émis par la source de lumière et transmis par la fibre optique, et simultanénent à soumettre l'échantillon à des gaz réactifs aptes à le graver.

21. Procédé selon la revendication 20, caractérisé en ce que les gaz réactifs sont à base d'halogènes.

22. Procédé de fabrication de motifs de résine photosensible, caractérisé en ce qu'il consiste à utiliser le dispositif selon l'une quelconque des revendications 1 à 14, à soumettre la résine à un faisceau lumineux émis par la source de lumière et transmis par la fibre optique, et simultanément à soumettre la résine à des gaz réactifs aptes à la graver.

## Claims

1. Apparatus for the production by the gaseous route and for the optical analysis of nanometre patterns on a sample, having a tight, sealed, gas expansion chamber (10) equipped with first gas supply means (12) for the production of patterns and having at a first end microcapillaries (24) for the discharge of the gas, an optical fibre (28), which is blunt (26) at a first end and which is placed facing the sample (18) to be treated, a light source coupled to a second end (28a) of the optical fibre emitting an incident beam (31), the latter being able to carry the beam emitted by the source, as well as means (48, 52) for detecting and means for processing (50) the light signal reflected by the sample.

2. Apparatus according to claim 1, characterized in that the micro-capillaries (24) are arranged in a ring around the optical fibre tip (26).

3. Apparatus according to claim 1 or 2, characterized in that the microcapillaries are inclined with respect to the optical fibre tip.

4. Apparatus according to any one of the claims 1 to 3, characterized in that the expansion chamber is sealed at its first end by a plug (22) equipped with said microcapillaries and in that the first end of the optical fibre traverses the plug in such a way that its tip projects out of the plug.

5. Apparatus according to any one of the claims 1 to 4, characterized in that a gas reserve chamber (8) equipped with second gas supply means (14) is provided.

6. Apparatus according to claim 5, characterized in that the two chambers (8, 4) are integral and are linked via said first means.

7. Apparatus according to claim 6, characterized in that the two chambers (8, 4) are arranged end to end and coaxially and are linked via said first means.

8. Apparatus according to any one of the claims 1 to 7, characterized in that means (37, 39) for dividing the incident beam from the light source are provided so as to produce a first light beam used for analysis and/or processing the sample and a second beam for checking the beam emitted by the source.

9. Apparatus according to any one of the claims 1 to 8, characterized in that display means (54) connected to the processing means are provided.

10. Apparatus according to any one of the claims 1 to 9, characterized in that the blunt part of the optical fibre facing the sample is covered, in its thinned portion, with the exception of its most pointed end (26a) by an outer coating (38) having high reflectivity at the wavelength of the incident beam from the source.

11. Apparatus according to any one of the claims 1 to 10, characterized in that the optical fibre is partly covered with a metal coating.

12. Apparatus according to any one of the claims 5 to 11, characterized in that the optical fibre is covered over its length, within the expansion and reserve chamber (8, 10), with a sheath (3), which protect it against the reactive gases located there.

13. Apparatus according to any one of the claims 1 to 12, characterized in that the second end (28a) of the blunt fire (28) is equipped with a standard connector (27) for an optical fibre and in that a coupling optical fibre (29) ensures the coupling of the blunt optical fibre (28) to the light source.

14. Apparatus according to any one of the claims 1 to 13, characterized in that means (56, 58, 50) are provided for performing a relative displacement between the optical fibre tip (26) and the sample (18) for focusing purposes.

15. Apparatus according to any one of the claims 1 to 14, characterized in that it constitutes an autonomous assembly.

16. Process for the direct, local pyrolytic deposition of a material on a sample, characterized in that it consists of using the apparatus according to any one of the claims 1 to 15, for irradiating the sample (20) by a light beam (31) emitted by the light source and transmitted by the optical fibre for heating said sample and simultaneously subjecting the sample to the action of gaseous precursors of said material, via the microcapillaries.

17. Process according to claim 16, applied to the local deposition of silicon, dielectric or a III-V compound, characterized in that the gaseous precursors are hydrides and/or metalorganics.

18. Process for the localized deposition of a material on a sample and which is photochemically assisted, characterized in that it consists of using the apparatus according to any one of the claims 1 to 14, exposing the sample to a light beam emitted by the light source and transmitted by the optical fibre and simultaneously exposing the sample to the action of gaseous precursors of said material, via the microcapillaries.

19. Process according to claim 18 applied to the local deposition of silica, characterized in that the gaseous precursors are silane and oxygen, in that the apparatus and the sample are placed in an oxygen atmosphere and in that the substrate is subject to the action of silane, via the microcapillaries.

20. Process for the local etching of a material, which is photochemically assisted, characterized in that it consists of using the apparatus according to any one of the claims 1 to 14, subjecting the sample to the action of a light beam emitted by the light source and transmitted by the optical fibre and simultaneously subjecting the sample to the action of reactive gases able to etch it.

21. Process according to claim 20, characterized in that the reactive gases are based on halogens.

22. Process for the production of photosensitive resin patterns, characterized in that it consists of using the apparatus according to any one of the claims 1 to 14, subjecting the resin to the action of a light beam emitted by the light source and transmitted by the optical fibre and simultaneously subjecting the resin to reactive gases able to etch it.

## Patentansprüche

1. Vorrichtung zur Herstellung von Mustern im Nanometerbereich auf einer Probe mittels Gasverfahren und optischer Analyse, die eine Gasexpansionskammer (10) umfaßt, welche abgeschlossen und abgedichtet ist und eine erste Versorgungseinrichtung (12) für Gas zur Herstellung der Motive aufweist und versehen ist mit einer optischen Faser (28) an einem ersten Ende von Mikrokapillaren (24) für den Gasausgang, die an einem ersten Ende abgestumpt (26) ist und gegenüber der zu behandelnden Probe (18) angeordnet ist, mit einer Lichtquelle, die an einem zweiten Ende (28a) der optischen Faser angekoppelt ist und einen einfallenden Strahl (31) aussendet, wobei diese letztere geeignet ist, den ausgesandten Strahl von der Quelle zu transportieren, und mit einer Einrichtung (48, 52) zum Detektieren und einer Einrichtung (50) zum Behandeln des Lichtsignals, das von der Probe reflektiert wird.

2. Vorrichtung nach Anspruch 1, **dadurch gekennzeichnet**, **daß** die Mikrokapillaren (24) kranzförmig um den Punkt (26) der optischen Faser angeordnet sind.

3. Vorrichtung nach Anspruch 1 oder 2, **dadurch gekennzeichnet**, **daß** die Mikrokapillaren in Bezug auf dem Punkt der optischen Faser geneigt sind.

4. Vorrichtung nach einem der vorangegangenen Ansprüche 1 bis 3, **dadurch gekennzeichnet**, **daß** die Expansionskammer an ihrem ersten Ende durch einen Pfropfen (22) abgeschlossen ist, der mit den Mikrokapillaren versehen ist, und daß das erste Ende der optischen Faser diesen Pfropfen in der Weise durchquert, daß sie über dem Pfropfen hinaussteht.

5. Vorrichtung nach einem der Ansprüche 1 bis 4, **dadurch gekennzeichnet**, **daß** eine Kammer (8) für Reservegas, die mit einer zweiten Einrichtung (14) zur Gasversorgung versehen ist, vorgesehen ist.

6. Vorrichtung nach Anspruch 5, **dadurch gekennzeichnet**, **daß** die zwei Kammern (8,4) einstückig sind und so vorgesehen sind, daß sie über die erste Einrichtung in Verbindung zu stehen.

7. Vorrichtung nach Anspruch 6, **dadurch gekennzeichnet**, **daß** die zwei Kammern (8,4) Ende an Ende angeordnet und koaxial sind und so vorgesehen sind, daß sie über die erste Einrichtung in Verbindung stehen.

8. Vorrichtung nach einem der Ansprüche 1 bis 7, **dadurch gekennzeichnet**, **daß** eine Einrichtung (37,39) zum Trennen des einfallenden Strahls, der von der Lichtquelle emittiert wird, in der Weise vorgesehen wird, daß ein erster Lichtstrahl entsteht, der zur Analyse und/oder Bearbeitung der Probe vorgesehen ist, und ein zweiter Lichtstrahl, der zur Steuerung des Strahles, welcher von der Quelle emittiert wird, vorgesehen ist.

9. Vorrichtung nach einem der Ansprüche 1 bis 8, **dadurch gekennzeichnet**, **daß** eine Visualisierungseinrichtung (54) vorgesehen ist, die mit der Bearbeitungseinrichtung verbunden ist.

10. Vorrichtung nach einem der Ansprüche 1 bis 9, **dadurch gekennzeichnet**, **daß** der abgestumpfte Teil der optischen Faser gegenüber der Probe an seinem spitzesten Ende (26a) beschichtet ist mit einer äußeren Schicht (38), die stark reflektiert bei einer Wellenlänge des einfallenden Strahls, der von der Quelle abgegeben wird.

11. Vorrichtung nach einem der Ansprüche 1 bis 10, **dadurch gekennzeichnet**, **daß** die optische Faser teilweise mit einer metallischen Schicht beschichtet ist.

12. Vorrichtung nach einem der Ansprüche 5 bis 11, **dadurch gekennzeichnet**, **daß** die optische Faser auf ihrer Länge im Innern der Expansionskammer und der Reservekammer (8,10) mit einer Ummantelung (33) umgeben ist, die sie vor reaktivem Gas schützt, das sich darin befindet.

13. Vorrichtung nach einem der Ansprüche 1 bis 12, **dadurch gekennzeichnet**, **daß** das zweite abgestumpfte Ende (28a) der Faser (28) mit einem Standardverbindungsanschluß (27) für optische Fasern versehen ist und daß eine optische Kopplungsfaser (29) die Kopplung der abgestumpften optischen Faser (28) mit der Lichtquelle sicherstellt.

14. Vorrichtung nach einem der Ansprüche 1 bis 13, **dadurch gekennzeichnet**, **daß** eine Einrichtung (56,58,50) vorgesehen ist, um eine relative Verschiebung zwischen dem Punkt (26) der optischen Faser und der Probe (18) in Hinsicht auf einen Bezugspunkt bewirkt.

15. Vorrichtung nach einem der Ansprüche 1 bis 14, **dadurch gekennzeichnet**, **daß** sie eine autonome Einheit bildet.

16. Verfahren zur direkten pyrolytischen lokalisierten Ablagerung eines Materials auf einer Probe, **dadurch gekennzeichnet**, **daß** sie die Verwendung der Vorrichtung nach einem der Ansprüche 1 - 15 umfaßt, mit einer Bestrahlung der Probe (20) mittels eines Lichtstrahl (31), der von einer Lichtquelle ausgesandt wird und mittels der optischen Faser übertragen wird, um die Probe zu erhitzen und gleichzeitig die Probe gasförmigen Vorläufern dieses Materials über die Mikrokapillaren auszusetzen.

17. Verfahren nach Anspruch 16, angewendet auf die lokale Ablagerung von Silizium, von Dielektrika oder einer Zusammensetzung III-V, **dadurch gekennzeichnet**, **daß** die gasförmigen Vorgänge Hydride sind und/oder organische Metalle.

18. Verfahren zur lokalisierten Ablagerung eines Materials auf einer Probe mit Hilfe von Photochemie, **dadurch gekennzeichnet**, **daß** es die Verwendung der Vorrichtung nach einem der Ansprüche 1 - 14 umfaßt, mit einem Aussetzen der Probe einem Lichtstrahl, der von der Lichtquelle ausgesandt und von der optischen Faser übertragen wird, und gleichzeitiges Aussetzen der Probe den gasförmigen Vorgängen dieses Materials über die Mikrokapillaren.

19. Verfahren nach Anspruch 18, angewendet auf die lokale Ablagerung von Siliciumdioxid, **dadurch gekennzeichnet**, **daß** die gasförmigen Vorgänge Silan und Sauerstoff sind, und daß man die Vorrichtung und die Probe in eine Sauerstoffatmosphäre stellt und daß man das Substrat über die Mikrokapillaren dem Silan aussetzt.

20. Verfahren zur lokalisierten Gravierung eines Materials, mit Hilfe von Photochemie, **dadurch gekennzeichnet**, **daß** man die Vorrichtung nach einem der Ansprüche 1 - 14 verwendet, und die Probe einem Lichtstrahl aussetzt, der von der Lichtquelle abgegeben wird und von der optischen Faser übertragen wird, und die Probe reaktives Gas aussetzt, das zur Gravierung geeignet ist.

21. Verfahren nach Anspruch 20, **dadurch gekennzeichnet**, **daß** die reaktiven Gase auf Halogenbasis sind.

22. Verfahren zur Herstellung von Motiven von photosensitivem Harz, **dadurch gekennzeichnet**, **daß** es die Verwendung der Vorrichtung nach einem der Ansprüche 1 - 14 umfaßt, mit einem Aussetzen des Harzes einem Lichtstrahl, der von der Lichtquelle abgegeben und von der optischen Faser übertragen wird, und gleichzeitiges Aussetzen des Harzes den reaktiven Gasen, die zur Gravur geeignet sind.
